(19) Europäisches Patentamt

European Patent Office

Office européen des brevets

(11) EP 0 877 467 A1

(12) EUROPEAN PATENT APPLICATION

(43) Date of publication:
11.11.1998 Bulletin 1998/46

(51) Int. Cl.$^6$: H02M 1/15, H03F 3/217, H03F 1/34

(21) Application number: 98107008.9

(22) Date of filing: 17.04.1998

(84) Designated Contracting States:
AT BE CH CY DE DK ES FI FR GB GR IE IT LI LU MC NL PT SE
Designated Extension States:
AL LT LV MK RO SI

(30) Priority: 09.05.1997 IT MI971092

(71) Applicant:
Elettronica 97 di Ing. Giovanni Casorerio & C. S.n.c.
20162 Milano (IT)

(72) Inventor: Casorerio, Giovanni
20142 Milano (IT)

(74) Representative:
Kratter, Carlo, Dr. Ing. et al
Ing. A. Giambrocono & C. s.r.l.
Via Rosolino Pilo 19 b
20129 Milano (IT)

(54) **Device for reducing the ripple component of the signal fed to a load by a switch mode power amplifier**

(57) A device for reducing the ripple component of the signal fed to a load (2) by a first switch mode power amplifier (1) via a feed line (5), comprising: at least one inductor (3), means (6) for acquiring the signal fed to the load, means (7) for extracting the ripple component from said signal, and means (4) for generating an electric signal ($V_2$) fed to said inductor, said means (4) for generating the electric signal ($V_2$) automatically varying this signal in relation to the value of the ripple component measured in the feed line, so as to reduce the ripple component in the signal fed to the load.

Fig. 2B

EP 0 877 467 A1

## Description

This invention relates to a device and method for reducing the ripple component in the signal fed to a load by a switch mode power amplifier. Although offering excellent efficiency and small overall size, power amplifiers of switch mode type, whether of duration modulation (PWM) or frequency modulation (PFM), produce an output signal which, in addition to possessing a component proportional to the input signal, also possesses an alternating component of frequency equal to or a multiple of the amplifier switching frequency. This component is commonly known as ripple, and will be indicated as such in the present context. The ripple of the signal present at the load connected to the amplifier must be reduced as much as possible, as it has a number of negative consequences. In this respect it is well known that, on account of the ripple, the load tends to increase in temperature because it is subjected to rapid voltage or current changes (eddy current losses). Again, the operation of the load is disturbed because it is subjected both to the required voltage or current component, and to the alternating ripple component. Moreover, the ripple is a source of noise, which is radiated and conducted along the conductors connected to the load or by the load itself.

To obviate the aforesaid drawbacks, it is known to use low-pass filters, generally comprising inductances or inductances and capacitors, positioned in series with the amplifier output and connected to the load. These methods have not proved totally effective, as they only partly reduce the ripple component.

A ripple reduction method known as "zero-ripple" is also known based on the use of a coupled inductor, in which respect reference should be made to the articles: "Practical design consideration for a multi-output CUK converter" and "The generalized use of integrated magnetics and zero-ripple techniques in switch mode power converters", published in the book "Mospower applications handbook", published in 1985 in the United States by Siliconix Incorporated. It should be firstly noted that the zero-ripple technique has been used up to the present time only in the field of direct current converters, or in the case in which the electrical characteristics of the load are stable and known.

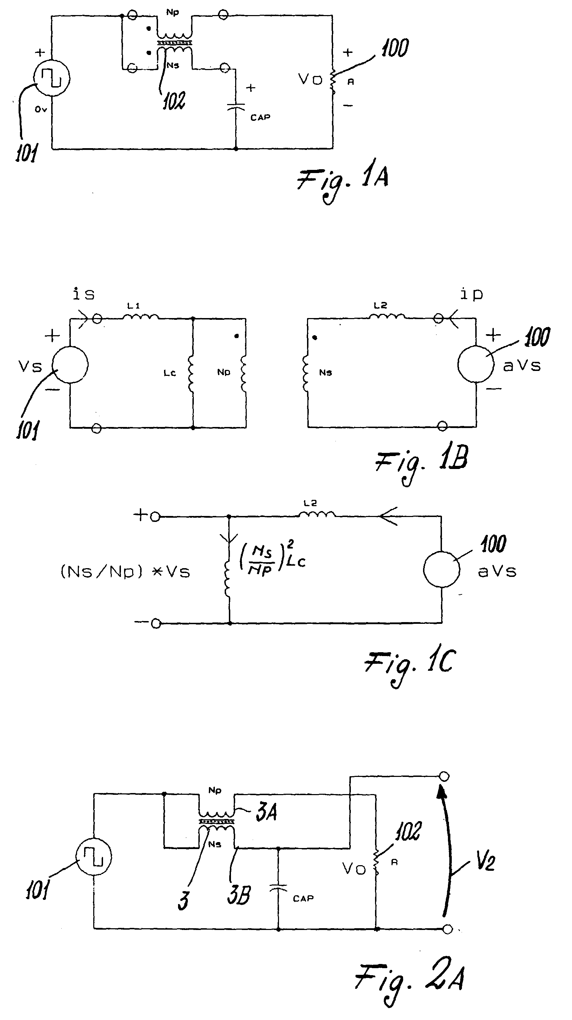

This technique uses only electronic components with very narrow constructional tolerances and having particular electronic characteristics (for example the inductance value) determinable by lengthy and complicated formulas. For example, in the case of the circuit of Figure 1A, modelled on the circuits of Figures 1B and 1C, to achieve a ripple current component reduced to zero in the primary circuit of the coupled inductor 102 connected to the load 100 and to the generator 101, the inductor must have a secondary-dispersed inductance $L_2 = (N_s/N_p)^2 . L_c [aN_p/N_s -1]$ where $N_s$ and $N_p$ are the number of turns of the secondary and of the primary respectively, and $L_c$ is the mutual inductance (for detailed treatment of this equation see the aforesaid article "The generalized use of integrated magnetics and zero-ripple techniques..."). To obtain an inductance value which satisfies this equation in the converter field, circuits have been developed comprising a trimmable inductance connected in series with the secondary circuit of the coupled inductor. The inductance is generally adjusted manually to obtain a ripple close to zero. This circuit and this adjustment are however dependent on the load characteristics, on the physical characteristics of the electronic components (for example on the inductor ferrite), on the temperature and on the circulating currents. Hence this type of circuit cannot be used for power amplifiers. Alternatively it is known to form coupled-inductor electronic circuits with an air gap of particular characteristics, such that they provide a ripple-free signal at the output of a primary circuit of the inductor (for more detailed treatment of the aforesaid known circuits, see the previously cited article). Again in this case, the calculation of the air gap characteristics is strictly related to precise temperature conditions, load and inductance. For these reasons this type of circuit also cannot be used for power amplifiers in which the load and utilization conditions vary, and counter-electromotive forces are present.

An object of the invention is to provide a device for reducing the ripple of a signal present in a load and generated by a switch mode power amplifier, the device being able to effectively reduce ripple even with loads of variable characteristics and, more generally, independently of the particular electrical characteristics of the various load components and of the environmental conditions (for example temperature).

A further object is to provide a device which does not require magnetic components to be trimmed nor the use of components with particular inductance characteristics, as required for the zero-ripple technique.

A further object is to provide a device by which ripple can be cancelled without limits on fed power.

A further object is to provide a device which behaves similarly to linear amplifiers, ie ripple tending to zero, high gain and wide pass band, even though using a switch mode amplifier.

These and further objects which will be apparent to an expert of the art are attained by a device in accordance with the accompanying claims.

The invention will be more apparent from the accompanying drawings, which are provided by way of non-limiting example and on which:

Figures 1A, B, C represent circuits of known converter devices;
Figures 2A, B are a schematic representation of a circuit to which a device of the invention can be applied, and a circuit comprising a device of the invention respectively;
Figures 3A-F show schematic voltage-time graphs relative to voltages measurable in the electrical schematic diagrams of Figures 3 and 4;
Figures 4, 5 show an electrical schematic diagram of a first possible embodiment;
Figures 6, 7 show modifications thereof.

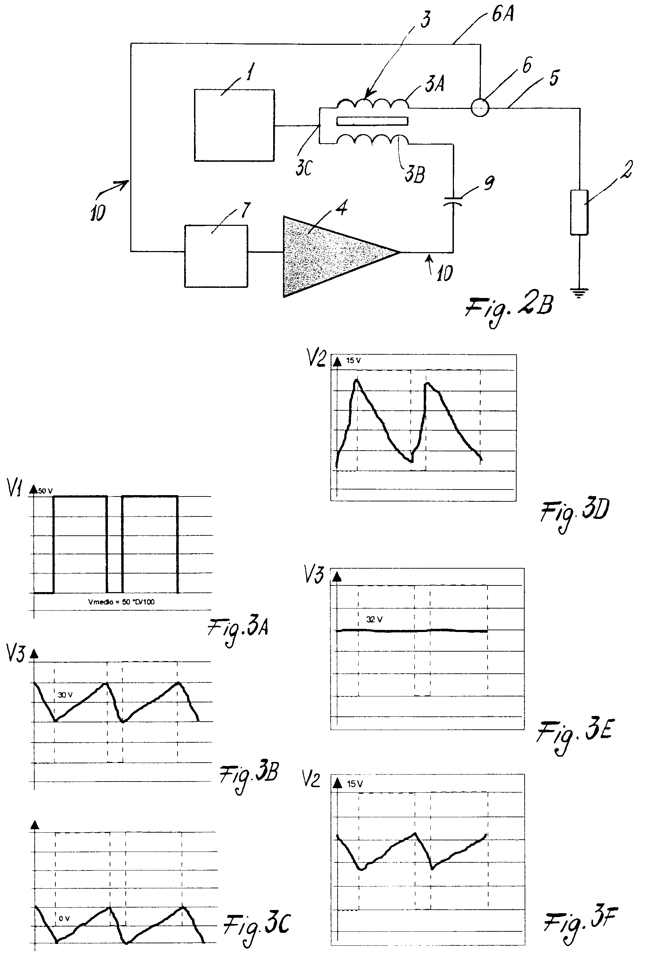

In a circuit of the type shown in Figures 2A, 2B, ie in a circuit in which a load 2, 102 is connected via the primary circuit of a coupled inductor 3 to a power amplifier 1 (Figure 2B) or to a generator 101 (Figure 2A), the method of the invention is able to drastically reduce the ripple component through the load, by applying to the secondary circuit 3B of the inductor a suitable electric signal $V_2$ (in Figure 2A) which varies on the basis of the ripple value determined through the load, and such as to reduce this ripple through the load.

In other words, as already seen, the condition for achieving zero ripple through the load in the circuit of Figure 1A, equivalent to that of Figure 1D, is that $L_2 = (N_s/N_p)^2 . L_c[aN_p/N_s-1]$.

By applying a modulated voltage $V_2$ to the secondary circuit 3B of the inductor 3, as the voltage of the generator 101, ie of the amplifier 1, is constant, the inductance of the inductor 3 can be controlled by modifying the value of the parameter "a" of the term $N_p/N_s$, with the value of $L_2$ given, such as to satisfy the necessary condition for obtaining the desired ripple reduction.

It should be noted that the method of the invention takes account of the possible variations of $L_2$, for example due to a different load or temperature, in that the voltage $V_2$ is modified automatically and continuously in relation to the ripple value measured through the load 2, 102.

Figure 2B shows a device for implementing the aforesaid method, the circuit of Figure 2B comprising a conventional switch mode power amplifier 1 which can be of duration modulation (PWM) type or frequency modulation type, connected to a load 2 fed with direct current, for example a stepping or brushless motor, a resistive load amplifier, or a generic electromechanical actuator. Between the amplifier 1 and the load 2 there is provided the coupled inductor 3, the primary circuit 3A of which is connected to a secondary line, indicated overall by 10, the common end 3C being controlled by the main power amplifier 1. To the line 5 of the load there are connected first means 6 for acquiring the signal applied to the load, and means 7 for extracting the ripple component from this signal.

The secondary line 10 connected to the secondary circuit 3B of the inductor 3 comprises a second amplifier 4 of lower power than the main amplifier, for processing only the ripple component "extracted" by the means 6 and 7 from the signal applied to the load. In the particular embodiment shown in Figure 2B the means 6, 7 and the amplifier 4 are connected together in a negative feedback loop 6A. The means for acquiring the signal applied to the load can comprise a simple electric cable 6A (as shown in Figure 1) for picking up the voltage or current present through the load 2, or a usual magnetic flux meter provided across the inductor. A Hall effect sensor could for example be used for this purpose. In this manner the primary circuit connected to the load would be decoupled, from the secondary line connected to the secondary of the inductor 3. This is particularly advantageous in the case of high feed voltages or currents. The ripple component processing means 7 can be usual band-pass and/or high-pass filters arranged to extract the alternating component from the signal through the load. More particularly, use can be made of band-pass filters centered on the switching frequency of the main amplifier 1 or high-pass filters which do not penalize the "rapid" variations in load power.

The ripple signal is then amplified and modified in phase so as to annul the ripple component present in the signal fed to the load. For this purpose, the output signal from the secondary amplifier 4 is fed through a coupling capacitor 9 to the secondary circuit 3B of the inductor 3 such that the ripple component of the signal fed to the load is discharged across the secondary, or discharged to earth, or to the positive of the power supply of the secondary amplifier 4.

The invention hence enables optimum reduction in ripple to be obtained, this being substantially forced to zero by the application of a suitable voltage or current through the secondary.

It should be noted that the negative feedback could be combined with positive feedback (forward feed). In this case, using a known microprocessor circuit, and knowing the operating parameters of the inductor, the output signal from the primary 3A of the inductor could be provided on the basis of the signal present through the secondary.

It should be noted that for implementing the device, conventional components can be used, the parameters of which do not have to be selected in accordance with special formulas as in the case of the zero-ripple technique, and that the device can operate under any load and/or external condition.

It should further be noted that the secondary amplifier does not have to handle the entire power transmitted to the load, but only that part which relates to the ripple which, generally, is of the order of 10% of the power fed. It is hence possible to use secondary amplifiers of low power, cost and overall size. These amplifiers can be of linear or switch mode type.

By virtue of the invention, the load can be fed with a signal substantially free of noise. Moreover, by using the output current and voltage of the load within a feedback loop, because of the absence of ripple very high loop gains and band widths can be obtained.

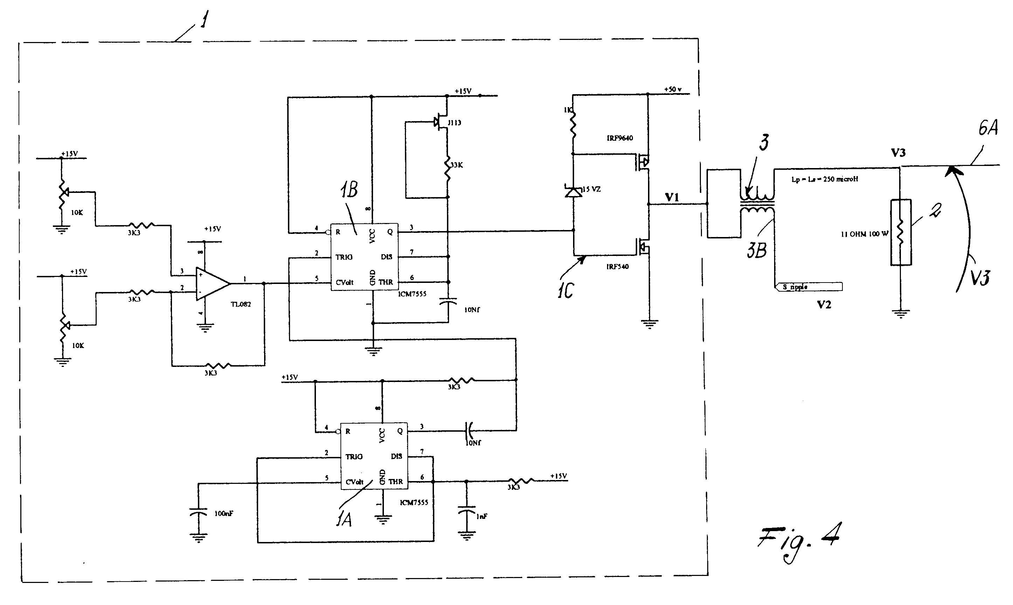

Figures 4 and 5 show, by way of example, a possible embodiment of the invention comprising a conventional switch mode power amplifier, indicated overall by 1 (but not described in detail as it is totally conventional to the expert of the art). The amplifier 1 is connected to a load 2, which in the example is a resistive load, via a coupled inductor 3.

The signal through the load is withdrawn in the form of voltage by acquisition means 6, which in the example are a branch 6A in parallel to the load, and is fed to the processing means 7, which in the example are a capacitor in series with a resistor, and to the secondary amplifier 4, which in the example is of linear type. The amplifier output 7A is connected via a conventional switch 8 to the secondary circuit 3B of the inductor 3.

Figure 3B shows the pattern of the voltage $V_3$, measured experimentally across the load 2, when the device of the invention is not inserted and with an output voltage $V_1$ from the amplifier 1 of the type shown in Figure 3A. In contrast, figure 3E shows the pattern measured for the voltage $V_3$ across the load 2 when the device of the invention is inserted. Figure 3C shows the pattern measured for the voltage $V_2$ fed to the secondary circuit of the inductor 3 by the second amplifier 4. As is apparent, on comparing Figures 3B and 3C, by subtracting the signal of Figure 3C from the signal of Figure 3B, the constant signal of Figure 3E without ripple is obtained. Finally, Figures 3D and 3F show the measured patterns for the output voltage $V_5$ from the second amplifier 4, with the invention inserted and not inserted respectively.

As can be deduced from the graphs of Figures 3A-F, when the device of the invention is inserted, the noise leaving the load is reduced to 100 milliV from the 10V measurable when the device is not inserted (the voltage concerned is the peak-peak voltage).

It has also been found that for a power of 94 W fed to the load, the power dissipated across the secondary amplifier is about 5 W (the measurement was made by measuring the temperature difference across a dissipator of known thermal resistance). The above results could be further improved by using a switch mode amplifier instead of the linear secondary amplifier 4 of Figure 4.

It has also been verified that the cancellation of the ripple was effectively due to the device of the invention, rather than to a possible filtering effect introduced by the coupling capacitor 9. This was verified by connecting the input of the secondary amplifier 4 to earth and connecting the output of this amplifier to the secondary circuit of the inductor 3 via the capacitor. In this case the voltage $V_3$ across the load is the same as in Figure 3B.

Figure 7 shows a circuit totally similar to that of Figure 4 (the part relative to the amplifier 1 has been omitted as it is identical to that of Figure 4). The only difference compared with the circuit of Figure 4 is that the inductor 4 is no longer of coupled type, but has a single coil 3D of inductance equal to that of the coils 3A-B of Figure 4. It has been found experimentally that even if the feedback circuit is connected directly to the downstream side of the inductor 3D and not to a secondary circuit, results are obtained comparable to those previously described. This single inductor device is particularly suitable when the load is fed at low power.

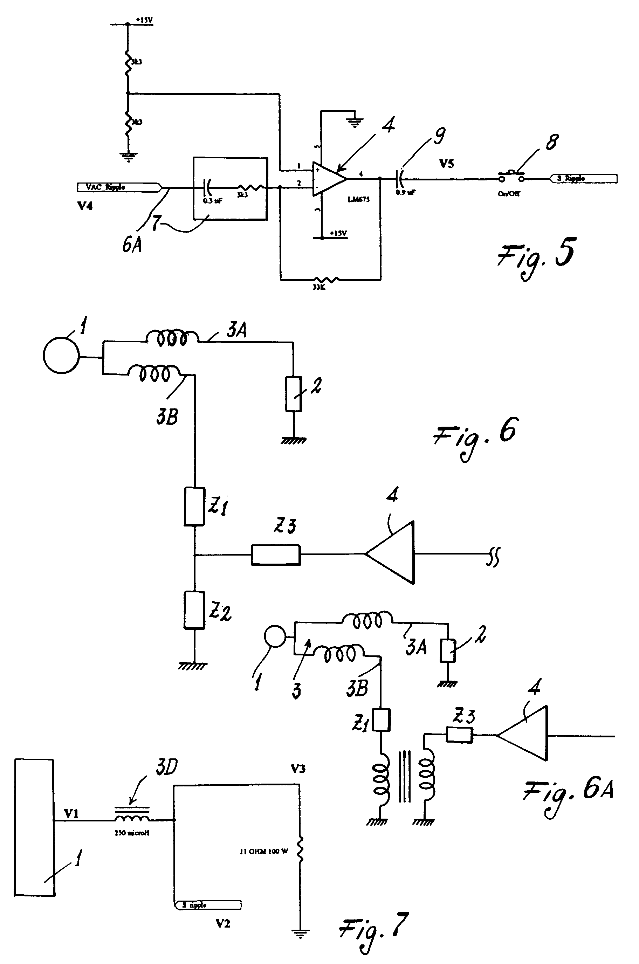

Figure 6 shows a modification to the schematic diagram of Figures 4, 5 in which the output of the secondary amplifier 4 is connected to the secondary circuit 3B of the inductor 3 via a first component z3 and second component z1 which can be of capacitive, inductive or short-circuit type, and in which there is provided a third component z2 connected to earth between the first two. This third component can be capacitive, inductive, an open circuit, or the secondary of a transformer as shown in Figure 6A. The choice of one or the other of the different types of component is related only to the particular secondary amplifier used, and does not affect the operation of the device. A scheme analogous to that of Figure 6 is also valid if the coupled inductor is replaced by a single inductor as in Figure 7.

It should be noted that the device of the invention can be formed either for coupling to, and reducing the ripple of, switch mode power amplifiers already in use, or for constructing switch mode power amplifiers with ripple reduction.

Finally it should be noted that the device of the invention can be used to reduce the ripple of the output signal from a generic power converter connected to a load via a line comprising an inductor of the type described for example in Figure 1A. The converter can be for example of the type described in the already cited articles, or of the type able to transform one alternating current electric signal into another alternating current signal of different characteristics, or a direct current signal into an alternating current signal, or, vice versa, an alternating current signal into a direct current signal.

## Claims

1. A device for reducing the ripple component of the signal fed to a load (2) by a power converter (1) via a feed line (5) comprising at least one inductor (3), characterised by comprising means (6) for acquiring the signal fed to the load, means (7) for extracting the ripple component from said signal, and, connected to said inductor, means (4) for generating an electric signal ($V_2$) fed to said inductor, said means (4) for generating the electric signal ($V_2$) automatically varying this signal in relation to the value of the ripple component measured in the feed line, so as to reduce the ripple component in the signal fed to the load.

2. A device as claimed in claim 1, characterised in that the power converter is a first switch mode power amplifier (1).

3. A device as claimed in claim 1, characterised in that the inductor is of the coupled type (3), its primary circuit (3A) being connected to the load (2), its secondary (3B) being connected to the means (4) for generating the electric signal arranged to reduce the ripple component, and the common node (3C) being connected to the power converter.

**4.** A device as claimed in claim 1, characterised in that the means for generating the electric signal fed to the inductor (3B) comprise a second power amplifier (4) of lower power than the first.

**5.** A device as claimed in claim 1, characterised in that the means (4) for generating the electric signal fed to the inductor receive as input a signal relative to the ripple component extracted from the means (7) for extracting said signal.

**6.** A device as claimed in claim 1, characterised in that the acquisition means (6), the extraction means (7) and the inductor feed means (4) are connected into a feedback loop.

**7.** A device as claimed in claim 1, characterised in that the means for extracting the ripple component comprise at least one filter element (7) of high-pass or band-pass type.

**8.** A device as claimed in claim 1, characterised in that the means (6) for extracting the signal fed to the load (2) are decoupled from the feed line.

**9.** A device as claimed in claim 1, characterised in that the means (6) for extracting the signal fed to the load (2) are directly connected to the feed line.

**10.** A device as claimed in claim 3, characterised by comprising means for providing the signal fed to the load, on the basis of the signal measured in the secondary circuit (3B) of the inductor.

**11.** A device as claimed in claim 1, characterised in that the electric signal fed to the inductor is a periodic alternating current or voltage signal.

**12.** A switch mode power amplifier, characterised by comprising, connected to its output line, a device for reducing the ripple component present in the signal fed to a load by said amplifier, said device being in accordance with one of claims 1 to 11.

**13.** A method for reducing the ripple component of the signal fed to a load by a first switch mode power amplifier via a feed line comprising at least one inductor, characterised by comprising a first stage in which the ripple component is extracted from the signal fed to the load, and a second stage in which an electric signal is fed to the inductor, said electric signal being varied automatically in relation to the value of the extracted ripple component, in such a manner as to obtain a reduction in the ripple component of the signal fed to the load.

**14.** A method as claimed in claim 13, characterised in that the electric signal is fed to the secondary circuit (3B) of a coupled inductor.

**15.** A method as claimed in claim 13, characterised by providing negative feedback of the ripple component extracted from the signal fed to the load.

Fig. 1A

Fig. 1B

Fig. 1C

Fig. 2A

6

Fig. 2B

V2 · 15 V

Fig. 3D

V1 · 50 V

Vmedia = 50 *DV/100

Fig. 3A

V3 · 30 V

Fig. 3B

V3 · 0 V

Fig. 3C

V3 · 32 V

Fig. 3E

V2 · 15 V

Fig. 3F

Fig. 4

EP 0 877 467 A1

Fig. 5

Fig. 6

Fig. 6A

Fig. 7

# EP 0 877 467 A1

**European Patent Office**

## EUROPEAN SEARCH REPORT

Application Number

EP 98 10 7008

## DOCUMENTS CONSIDERED TO BE RELEVANT

| Category | Citation of document with indication, where appropriate, of relevant passages | Relevant to claim | CLASSIFICATION OF THE APPLICATION (Int.Cl.6) |
|---|---|---|---|
| X | US 4 594 648 A (GALLIOS GEORGE C) 10 June 1986<br>* the whole document *<br>--- | 1,3-11 | H02M1/15<br>H03F3/217<br>H03F1/34 |
| X | US 4 667 279 A (MAIER CRAIG P) 19 May 1987 | 1,3-7, 10,11 | |
| Y | * the whole document *<br>--- | 2,8,9, 12-15 | |
| Y | US 5 329 245 A (HAMMOND RUSSELL E  ET AL) 12 July 1994<br>* abstract; figures 5,7 *<br>--- | 2,8,9, 12-15 | |
| A | US 4 346 349 A (YOKOYAMA KENJI) 24 August 1982<br>* abstract; figure 9 *<br>----- | 12-15 | |
| | | | **TECHNICAL FIELDS SEARCHED (Int.Cl.6)**<br>H03F<br>H02M |

The present search report has been drawn up for all claims

| Place of search | Date of completion of the search | Examiner |
|---|---|---|
| THE HAGUE | 7 August 1998 | Segaert, P |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

10